# EUROPÄISCHE PATENTSCHRIFT

(11) **EP 2 807 743 B1**
(45) Veröffentlichungstag und Bekanntmachung des Hinweises auf die Patenterteilung: **13.01.2016**
(21) Anmeldenummer: 13702002.0
(22) Anmeldetag: 24.01.2013
(51) Int. Cl.: H02P 29/00, H02J 3/38, F03D 9/00, H02J 3/01, F03D 7/04, G01R 23/167

(54) **WINDPARK-OBERSCHWINGUNGSPRÄDIKTOR UND VERFAHREN DAZU**
WIND FARM HARMONIC PREDICTOR, AND METHOD THEREFOR
PRÉDICTEUR D'OSCILLATIONS HARMONIQUES POUR PARC D'ÉOLIENNES ET PROCÉDÉ CORRESPONDANT

(30) Priorität: 24.01.2012 US 201261590100 P
(43) Veröffentlichungstag der Anmeldung: 03.12.2014
(73) Patentinhaber: Senvion GmbH, 22297 Hamburg (DE)
(72) Erfinder: LETAS, Heinz-Hermann, 24796 Bovenau (DE)
(74) Vertreter: Glawe, Delfs, Moll
(86) Internationale Anmeldenummer: PCT/EP2013/051311
(87) Internationale Veröffentlichungsnummer: WO 2013/110691

(56) Entgegenhaltungen:
- EP-A2- 1 959 136
- EP-A2- 2 209 200
- US-A1- 2009 150 126

## Beschreibung

Die Erfindung betrifft einen Windpark mit mindestens zwei Windenergieanlagen, die jeweils einen Generator mit einem Umrichter zur Erzeugung elektrischer Energie aufweisen.

Es ist bei einem Betrieb von Windpark am elektrischen Übertragungsnetz wegen der zunehmenden Anzahl und Größe der Windparks von steigender Bedeutung, dass sie stabilisierend auf das Netz wirken. Die Windparks leisten damit ihren Beitrag zur Sicherung der Stabilität des Stromnetzes. Ein wesentlicher Parameter der Netzqualität ist der Oberschwingungsgehalt. Einschlägige Verordnungen begrenzen Amplitude in Abhängigkeit von der Ordnung der Oberschwingungen, um eine ausreichende Netzqualität zu erhalten. Moderne Umrichter gesteuerte Windenergieanlagen erzeugen aufgrund der Schaltvorgänge im Umrichter Oberschwingungen verschiedener Art, sowohl solche mit gerader sowie ungerader Ordnung wie auch solche mit starrer Phasenlage zum Netz oder solche mit variabler Phasenlage zum Netz. Die Windenergieanlagen werden im Rahmen einer für jeden Windenergieanlagentyp vorzunehmenden Typprüfung vermessen und daraus Kennwerte bestimmt. Sind mehrere Windenergieanlagen an das Netz anzuschließen, wie im Fall eines Windparks, werden in der Regel die Oberschwingungen mit Hilfe eines Rechenverfahrens aus den Werten für die einzelnen Windenergieanlagen bestimmt. Die vom Windpark insgesamt abgegebenen Oberschwingungen müssen unterhalb gewisser Grenzwerte bleiben.

In der Praxis wirkt sich dies oft limitierend auf den Windpark aus. Das optimierte Oberschwingungsverhalten von Windparks mit mehreren Windenergieanlagen ist Gegenstand verschiedener Druckschriften, z.B. EP2209200 und E1959136.

Bei der Berechnung der Oberschwingungen für Windparks basierend auf den zertifizierten Messwerten für die einzelne Windenergieanlage wird je nach Art der Oberschwingung unterschiedlich vorgegangen: Oberschwingungen mit niedrigen ungeraden Ordnungszahlen werden als typisch für maschinen- oder netzgeführte Umrichter in Thyristortechnik angesehen. Die Oberschwingungen sind bezogen auf die Grundschwingung phasenstarr und die Oberschwingungen der einzelnen Windenergieanlagen addieren sich skalar auf. Es ergibt sich für einen Park mit N Windenergieanlagen der N-fache Wert einer einzelnen Windenergieanlage. Oberschwingungen höherer Ordnung, insbesondere im Bereich der Umrichterschaltfrequenz, werden als typisch für freilaufende Pulswechselrichter angesehen. Die Phasenlage der damit versehenen Windenergieanlagen ist nicht fest auf die Grundschwingung bezogen, sondern kann relativ zu ihr driften. Tatsächlich ist die Phasenlage statistisch gleichverteilt. Damit addieren sich die Werte der einzelnen Windenergieanlagen nicht direkt auf, sondern entsprechend der statistischen Verteilung kann für diese Oberschwingungen ein Anwachsen entsprechend der Quadratwurzel der Windenergieanlagen angesetzt werden (100 Windenergieanlagen erzeugen damit nicht den 100-fachen, sondern nur den 10-fachen Wert einer einzelnen Windenergieanlage). Da bezogen auf das Vorgehen bei niedrigen Ordnungszahlen mit der skalaren Vervielfachung sich eine Verringerung ergibt, spricht man auch von einem Reduktionsfaktor mit 1/√(N).

In den Verordnungen nur unzureichend betrachtet sind Oberschwingungen mit niedrigen, aber geraden Ordnungszahlen. In der Regel enthalten sie einen beträchtlichen phasenstarren Anteil, sind also gemischt phasenstarr und phasenvariabel. Der auf phasenvariable Oberschwingungen anwendbare Reduktionsfaktor 1/√(N) kann daher nicht zur Anwendung kommen. Herkömmlicherweise erfolgt daher eine direkte, skalare Addition ohne Reduktion. Dies ist unbefriedigend, da die Grenzwerte häufig recht niedrig liegen wodurch die Größe des Windparks hinsichtlich der Zahl der Windenergieanlagen deutlich beschränkt wird.

Außerdem macht die Verschiedenheit der Berechnungsverfahren je nach Art der Oberschwingung die Anwendung umständlich.

Der Erfindung liegt die Aufgabe zugrunde, diesen Nachteil zu vermeiden und eine universelle Reduktion zu erreichen, die für alle geraden, ungeraden und auch auf Zwischenfrequenzen liegende Oberschwingungen anwendbar ist, und zwar insbesondere auch bei niedrigen geraden Oberschwingungen.

Die erfindungsgemäße Lösung liegt in den Merkmalen der unabhängigen Ansprüche 1, 7 und 9. Vorteilhafte Weiterbildungen sind Gegenstand der abhängigen Ansprüche.

Bei einem Windpark mit mindestens zwei Windenergieanlagen, die jeweils einen Generator mit einem Umrichter zur Erzeugung elektrischer Energie aufweisen, ist erfindungsgemäß vorgesehen ein Oberschwingungsprädiktor, der die vom Windpark erwartete Oberschwingung bestimmt zur Begrenzung auf einen Oberschwingungsgrenzwert, und der dazu ausgebildet ist mit einem Berechnungsmodul, das einen komplexen Mittelwert über mindestens eine Periode der Oberschwingung einer der Windenergieanlagen berechnet und daraus einen ersten Ersatzvektor bestimmt, einem Iterationsmodul, welches das Berechnungsmodul sukzessive auf mindestens eine andere der Windenergieanlagen aufschaltet zur Bildung mindestens eines zweiten Ersatzvektors, und einem Summiermodul, welches die Ersatzvektoren aufaddiert zu einem Gesamtvektor und mit dem Oberschwingungsgrenzwert vergleicht.

Zuerst seien einige verwendete Begriffe erläutert:

Unter einem komplexen Mittelwert wird ein Mittelwert verstanden, der in der komplexen Zahlenebene unter Berücksichtigung von Realteil und Imaginärteil der Oberschwingung berechnet wird. Es handelt sich also um eine komplexe Zahl.

Unter "sukzessive ... aufschaltet" wird verstanden, dass das Iterationsmodul mit dem Berechnungsmodul derart zusammenwirkt, dass der komplexe Mittelwert gebildet wird für eine zweite Windenergieanlage, und ggf. für eine dritte, vierte und weitere Windenergieanlagen, so dass dementsprechend zweite, dritte, vierte und ggf. weitere Ersatzvektoren gebildet werden.

Die Erfindung fußt auf der Erkenntnis, dass eine genauere Abschätzung der von den Windenergieanlagen eines Windparks insgesamt abgegebenen Oberschwingung ermöglicht ist durch Berücksichtigung der jeweiligen mittleren Phasenlagen. Die Erfindung erreicht dies auf elegante Weise durch Kombination von einer Berechnung für jede Windenergieanlage für sich, wobei die sukzessive in einem Iterationsverfahren für alle zu betrachtenden Windenergieanlagen des Windparks durchgeführt wird, mit einer anschließenden Aufaddierung über die einzelnen Windenergieanlagen. Damit ist die nur schwierig durchführbare Berechnung des Windparks im Gesamten rückgeführt auf eine Berechnung der einzelnen Windenergieanlagen, wobei durch die Ausbildung des Berechnungsmoduls mit Implementation eines komplexen Mittelwertbildners eine phasenrichtige Berücksichtigung erreicht werden kann. Windenergieanlagen mit phasenvariablen Teilen der Oberschwingungen, die versetzt zueinander liegen, heben sich damit teilweise auf bzw. addieren sich in nur geringem Maße. Mit dieser vektoriellen Aufaddierung wird schließlich ein Gesamtvektor für den gesamten Windpark bestimmt, der beträchtlich kleiner ist als der herkömmlicherweise berechnete.

Die Erfindung hat erkannt, dass ein auf dieser Grundlage gebildeter Prädiktor die Oberschwingungen auch in solchen Fällen hinreichend genau abschätzt, bei denen die Oberschwingungen aus phasenstarren und phasenvariablen Bestandteil bestehen. Herkömmlicherweise konnten nur Fälle mit rein phasenvariablen Oberschwingungen durch vektorielle Addition bestimmt werden. Die Erfindung ermöglicht dies nun auch für Mischfälle, und erreicht damit einen breit einsetzbaren Prädiktor. Er eignet sich für alle Oberschwingungen, seien es gerade, ungerade oder solche auf Zwischenfrequenzen. Insbesondere eignet sich dieser Prädiktor auch zur Verwendung bei den bisher nur unzureichend berücksichtigten geraden Oberschwingungen niedriger Ordnung.

Mittels des erfindungsgemäßen Prädiktors kann somit eine wesentlich genauere Abschätzung der vom Windpark insgesamt abgegebenen Oberschwingung erreicht werden, und zwar gerade auch und besonders in den Fällen, in denen die Oberschwingung ein Mischfall aus phasenstarrem und phasenvariablem Teil sind. Damit ergibt sich ein erheblicher Vorsprung im Vergleich zu der im Stand der Technik bisher üblichen Abschätzung basierend auf einer reinen skalaren Addition. Mit dem erfindungsgemäßen Prädiktor ist es damit ermöglicht, mehr Windenergieanlagen an einen gegebenen Anschluss anzuordnen.

Zweckmäßigerweise sind das Iterationsmodul und das Summiermodul kombiniert zu einem Rekursionsmodul. Damit kann auf einfache und gut nachvollziehbare Weise die Oberschwingung für eine zunehmende Anzahl von Windenergieanlagen im Windpark bestimmt werden. Damit ist es möglich, die Rekursion dann abzubrechen, wenn der Oberschwingungsgrenzwert erreicht ist. Der Oberschwingungsprädiktor gibt auf diese Weise unmittelbar die Anzahl der maximal anschließbaren Windenergieanlagen für einen Windpark direkt aus. Für die praktische Anwendung ist dies eine erhebliche Erleichterung.

Vorzugsweise weist das Berechnungsmodul eine Offset-Einheit für einen phasenstarren Teil der Oberschwingung der Windenergieanlage, einen Rotator für einen phasenvariablen Teil der Oberschwingung und einen Vektorisierer auf, der dazu ausgebildet ist, den Ersatzvektor basierend auf Mittelwerten von Offset-Einheit und Rotator nach Betrag und Winkel zu bestimmen. Mittels der Offset-Einheit kann insbesondere der phasenstarre Teil auf einfache Weise bestimmt werden. Charakteristisch für diesen ist, dass er für die betrachteten Windenergieanlagen des Windparks typischerweise immer dieselbe Phase aufweist. Er kann also mittels der Offset-Einheit vereinfacht berechnet werden. Für den phasenvariablen Teil ist vorzugsweise der Rotator vorgesehen, der dem variabel umlaufenden Teil der Oberschwingung repräsentiert. Der phasenvariable Teil ist bei den verschieden betrachteten Windenergieanlagen definitionsgemäß nicht starr verkuppelt, sondern unabhängig von einander. Bei einer vektoriellen Berechnung ergeben sich also unterschiedliche Richtungen für die Vektoren (selbst wenn sie alle denselben Betrag bzw. Länge aufweisen), so dass sich wegen der Winkelverschiedenheit hierin die gewünschte Reduktion abbildet. Der Vektorisierer erfasst diese Unterschiede bezüglich der Winkel und berücksichtigt sie bei der Aufaddition, um schließlich den Ersatzvektor zu bestimmen, der durch einen bestimmten Betrag (Länge des Vektors) und Winkel (Phasenlage) bestimmt ist.

Bei einer besonders vorteilhaften Ausführungsform, die ggf. unabhängigen Schutz verdient, ist der Umrichter der Windenergieanlage bezüglich seines phasenstarren und phasenvariablen Teils der Oberschwingung einstellbar. Es hat sich gezeigt, dass Oberschwingungen bei modernen hochfrequenten Pulswechselrichtern zwar nicht (vollständig) vermieden werden können, jedoch in Bezug auf ihre mittlere Phasenlage beeinflusst werden können. In dem die Gewichtung zwischen phasenstarrem und phasenvariablem Teil verschoben wird, kann somit Betrag und vor allem Winkellage des Ersatzvektors beeinflusst werden. Damit können für die einzelnen Windenergieanlagen solche Werte eingestellt werden, dass sie sich in ihrem Einfluss auf die Oberschwingungen möglichst weitgehend gegenseitig neutralisieren. Damit ist es ermöglicht, mehr Windenergieanlagen im Windpark vorzusehen ohne den Oberschwingungsgrenzwert zu überschreiten. Dazu wirkt zweckmäßigerweise der Oberschwingungsprädiktor mit einem Limiter zusammen. Dieser verstellt das Verhältnis zwischen phasenstarren und phasenvariablen Teil derart, dass eine Reduktion auf den gewünschten Grenzwert erreicht ist. Der Limiter kann alternativ oder zusätzlich auch so ausgebildet sein, dass die Anzahl der Windenergieanlagen begrenzt wird, welche elektrische Energie abgeben, um so in kritischen Fällen die Einhaltung der Oberschwingungsgrenzwerts zu garantieren.

Vorzugsweise ist der Oberschwingungsprädiktor besonders für Oberschwingungen gerader Ordnung ausgebildet, und zwar insbesondere bis solchen zur 50. Ordnung. Besonders bevorzugt ist eine Auslegung für tiefe Oberschwingungen (bis zur 20. Ordnung) und/oder hohe Oberschwingungen in Bereich der Schaltfrequenz des Umrichters.

Die Erfindung erstreckt sich weiter auf ein Verfahren zum Begrenzen der von einem Windpark generierten Oberschwingung, wobei der Windpark mindestens zwei Windenergieanlagen umfasst, die jeweils einen Generator mit einem Umrichter zur Erzeugung elektrischer Energie aufweisen, wobei erfindungsgemäß vorgesehen ist für eine erste der Windenergieanlagen ein Berechnen eines komplexen Mittelwerts über mindestens eine Periode der Oberschwingung und daraus bestimmen eines ersten Ersatzvektors mit Betrag und Winkel, und für mindestens eine zweite der Windenergieanlagen iteratives Bestimmen eines zweiten Ersatzvektors auf dieselbe Weise, und schließlich Verwenden des ersten Ersatzvektors als Fußpunkt für den zweiten Ersatzvektor zur Aufsummation und abschließendes Bilden eines Gesamtvektors und dessen Vergleich mit dem Oberschwingungsgrenzwert. Unter Fußpunkt eines Vektors wird die der Spitze gegenüberliegende Seite verstanden.

Zur näheren Erläuterung des Verfahrens wird auf die vorstehend zu dem Windpark gegebene Erläuterung verwiesen.

Die Erfindung erstreckt sich ferner auf einen entsprechenden Oberschwingungsprädiktor für einen Windpark und das entsprechende Verfahren. Es wird auf vorstehende Erläuterungen verwiesen. Zusätzlich wird angemerkt, dass der Oberschwingungsprädiktor zweckmäßigerweise mit einem Simulationsinterface versehen sein kann. Dieses dient dazu, als Schnittstelle zu einer Simulationsumgebung zu fungieren, in der der Windpark mit seinen Windenergieanlagen implementiert ist. Dies ermöglicht eine Anwendung des erfindungsgemäßen Oberschwingungsprädiktors auch bereits bei Windparks in deren Entwurfs- und Planungsphase, also ohne dass sie bereits realisiert zu sein müssen. Damit ergibt sich eine erhebliche Erweiterung des Anwendungsspektrums des erfindungsgemäßen Oberschwingungsprädiktors.

Die Erfindung wird nachfolgend in Bezugnahme auf die beigefügten Zeichnungen erläutert, in der ein vorteilhaftes Ausführungsbeispiel dargestellt ist. Es zeigen:
- Figur 1:: eine Übersichtsdarstellung eines Windparks mit einem Oberschwingungsprädiktor gemäß der Erfindung;
- Figur 2:: eine alternative Ausführungsform mit dem erfindungsgemäßen Oberschwingungsprädiktor;
- Figur 3:: ein Diagramm für die mit dem Oberschwingungsprädiktor erreichte Reduktion der Oberschwingung;
- Figur 4:: eine Darstellung des phasenstarren und phasenvariablen Anteils der Oberschwingung einer Windenergieanlage;
- Figur 5:: Beträge und Mittelwerte der Oberschwingung über eine Periode hinweg dargestellt;
- Figur 6:: eine grafische Veranschaulichung des Prädiktionsverfahrens für drei Windlenergieanlagen; und
- Figur 7:: eine erweiterte Darstellung für eine große Anzahl von Windenergieanlagen im Windpark.

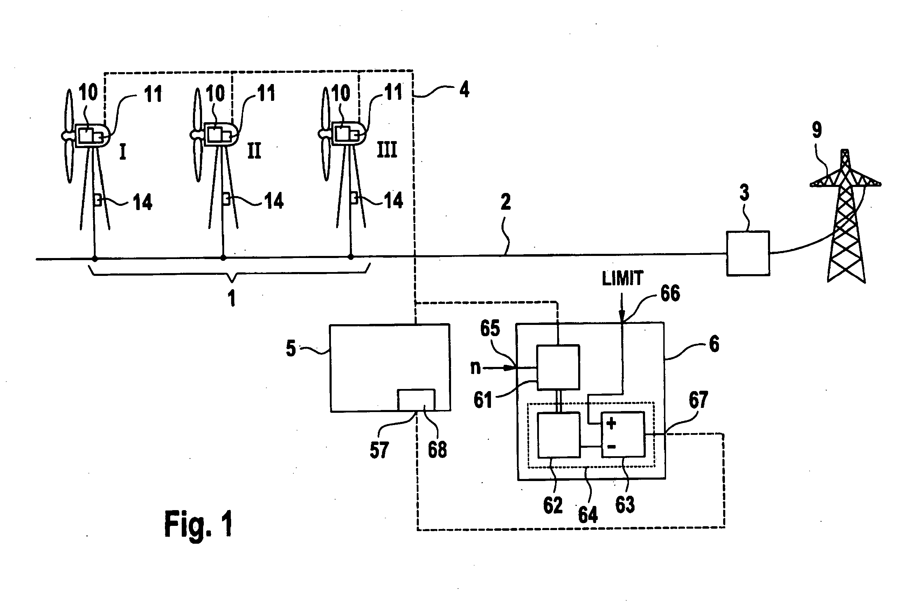

Ein Ausführungsbeispiel für einen Windpark mit einem erfindungsgemäßen Oberschwingungsprädiktor ist in Figur 1 dargestellt. Der Windpark umfasst eine Mehrzahl von Windenergieanlagen 1, wobei im dargestellten Ausführungsbeispiel drei Windenergieanlagen vorgesehen sind. Sie sind gleichartig aufgebaut und zur Identifikation mit den römischen Zahlen I, II bzw. III gekennzeichnet. Die Windenergieanlagen 1 weisem jeweils einen doppelt gespeisten Asynchrongenerator 10 mit einem Umrichter 11 auf und sind zur Abgabe der erzeugten elektrischem Energie an ein Sammelnetz 2 angeschlossen, das als ein Mittelspannungsnetz ausgebildet ist. Es führt zu einem Anschlusspunkt 3, der üblicherweise einen Hochspannungstransformator (nicht dargestellt) zum Anschluss an ein Hochspannungsnetz 9 beinhaltet.

Weiter ist ein Windparkmaster 5 vorgesehen, welcher eine übergeordnete Regelung für die Windenergieanlagen des Windparks ausübt. Der Windparkmaster 5 ist über ein gesondertes Signalleitungsnetz 4 mit den Windenergieanlagen 1 verbunden.

Außerdem angeschlossen an das Signalleitungsnetz 4 ist ein Oberschwingungsprädiktor 6. Er umfasst ein Berechnungsmodul 61, ein Iterationsmodul 62 sowie eim Summiermodul 63. Das Iterationsmodul 62 und das Summiermodul 63 sind zu einem Rekursionsmodul 64 zusammengefasst. An dem Berechnungsmodul 61 ist ein Eingang 65 für die Ordnung der vom Oberschwingungsprädiktor zu behandelnden Oberschwingung n angeordnet. Üblicherweise werden hier kleine gradzahlige Ordnungszahlen vorgegeben. Weiter ist an dem Oberschwingungsprädiktor 6 ein Eingang 66 für einen Oberschwingungsgrenzwert vorgesehen. Ein Ausgangsanschluss 67 des Oberschwingungsprädiktors 6 ist rückgeführt zu einem Limiter 68, der an dem Parkmaster 5 angeordnet ist.

Über das Signalleitungsnetz 4 werden von der Windenergieanlage 1 Signale zu der zu behandelnden Oberschwingung bereitgestellt, und zwar insbesondere in Bezug auf den phasenstarren und phasenvariablen Anteil. In der Regel liegen diese Informationen in einer Betriebssteuerung der Windenergieanlage 1 vor und können daraus abgefragt werden, da diese über entsprechende Sensoren in der Windenergieanlage 1 selbst verfügt. Es kann aber auch vorgesehen sein, dass die entsprechenden Werte durch Sensoren 14 an den einzelnen Windenergieanlagen gesondert erfasst und über das Signalleitungsnetz 4 übermittelt werden.

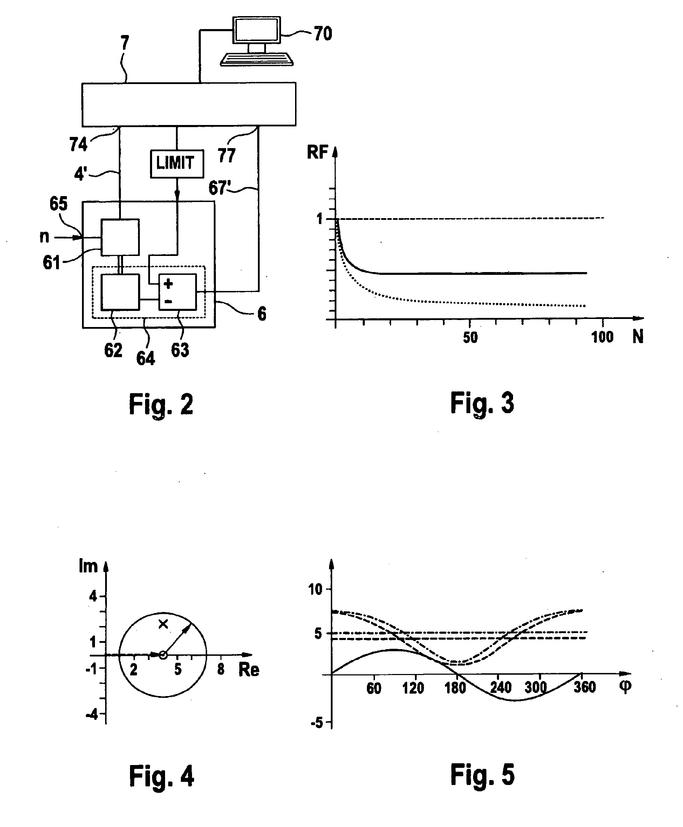

Aus den somit angelegten Werten bestimmt das Berechnungsmodul 61 einen komplexen Mittelwert der Oberschwingung über mindestens eine volle Periode und berechnet daraus einen Ersatzvektor. Dies wird nachfolgend unter Bezugnahme auf die Figuren 4 und 5 näher dargestellt.

In Figur 4 ist in der komplexen Ebene eine Oberschwingung einer der Windenergieanlagen, als Beispiel dient die Windenergieanlage I, dargestellt. Die Oberschwingung weist einen phasenstarren Teil sowie einen phasenvariablen Teil auf. Das Koordinatensystem für die komplexe Darstellung der Oberschwingung ist so gewählt, dass der phasenstarre Teil auf der reellen Achse liegt. Der phasenstarre Teil ist in Figur 4 mit einem gestrichelten horizontalen Pfeil dargestellt. Zu dem phasenstarren Teil tritt hinzu der phasenvariable Teil, der als ein kreisförmig umlaufender Vektor dargestellt ist mit einem dünnen durchgezogenen Pfeil. Dieser Pfeil läuft um (rotiert) mit der sich aus der Ordnung der Oberschwingung ergebenden Frequenz. Der Gesamtwert der Oberschwingung wird zu jedem beliebigen Zeitpunkt durch die Spitze des dünnen Pfeils, dessen Fußpunkt an der Spitze des gestrichelten Pfeils für den phasenstarren Teil liegt, repräsentiert. Daraus ergeben sich die in Figur 5 dargestellten Kennwerte. Der Realteil der Oberschwingung ist in Figur 5 durch die gestrichelte Linie dargestellt, und der Imaginärteil der Oberschwingung ist durch die durchgezogene Linie dargestellt. Der Betrag der komplexen Zahl, die durch den jeweiligen Realteil und Imaginärteil definiert ist, wird durch die strichpunktierte Linie dargestellt. Auffällig ist, dass diese Linie anders als die Linien für den Real- bzw. Imaginärteil keinen sinusförmigen Verlauf aufweist, sondern vielmehr im Bereich um den Winkel 180° eine Abplattung aufweist. Dies ergibt sich daraus, dass bei Betrachtung der Pfeilspitze der durchgezogenen Linie in Figur 4 diese bei dem Durchlauf am linken Ende des Kreises, also in dem der Imaginärachse zugewandten Bereich, einen beinahe gleichmäßigen Abstand zu dem Ursprung aufweist. Das bedeutet, dass in diesem Bereich der Betrag des vom Ursprung zu der Spitze des durchgezogenen Pfeils laufende Vektor für die gesamte Oberschwingung minimal ist. Die Abplattung resultiert also letztlich aus der Überlagerung der linearen Verschiebung durch den phasenstarren Anteil, der wie ein Offset wirkt, und der Rotation durch den phasenvariablen Teil.

Weiter in Figur 5 dargestellt sind als Horizontallinien die Mittelwerte für den Realteil (gestrichelt) und der Mittelwert für den Gesamtwert der Oberschwingung (phasenstarrer und phasenvariabler Teil) in strichpunktierter Darstellung. Der Mittelwert für den komplexen Vektor der Oberschwingung ist ebenfalls komplex und ist in Figur 4 durch ein Kreuz dargestellt. Dieser dient erfindungsgemäß als Ersatzwert für die Oberschwingung, dessen Betrag der mittleren Amplitude der Oberschwingung entspricht. Das Berechnungsmodul 61 liefert an seinem Ausgang diesen komplexen Mittelwert als Ersatzvektor.

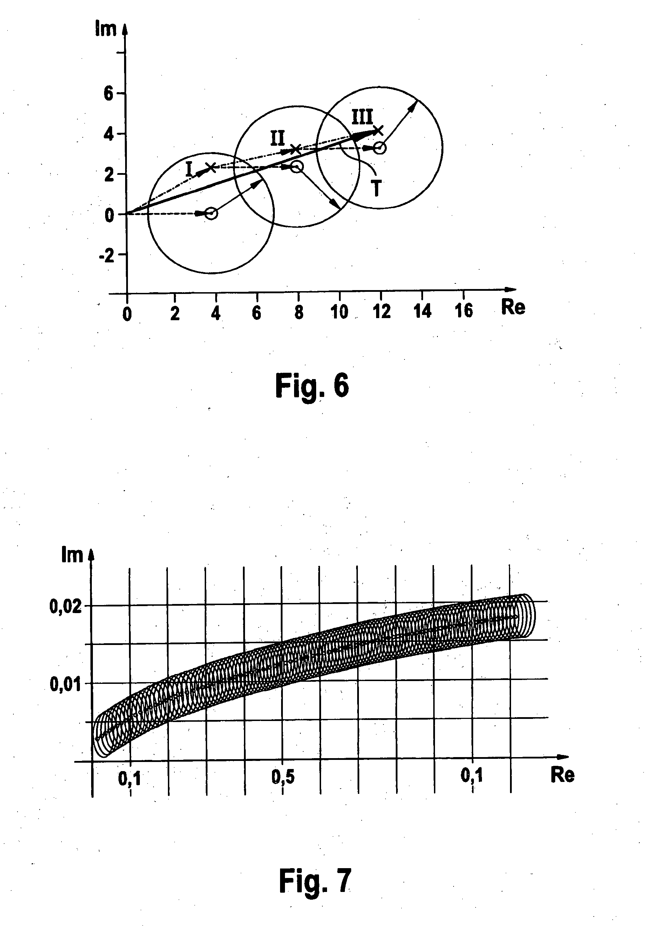

Das Iterationsmodul 62 sorgt dafür, dass die vorstehend am Beispiel der Windenergieanlage I dargestellte Berechnung für die weiteren Windenergieanlagen, im Beispiel II und III, entsprechend wiederholt wird. Das Summiermodul 63 addiert diese Werte auf. Dies ist in Figur 6 visualisiert. Sie enthält drei kreisartige Darstellungen, die mit den römischen Zahlen I, II und III bezeichnet sind für die drei Windenergieanlagen. Die Darstellung des ersten Kreises entspricht derjenigen in Figur 4 für die Windenergieanlage I. Deren als Ersatzwert fungierender Ersatzvektor ist durch den strichpunktierten Pfeil nahe der römischen Zahl I dargestellt. Ausgehend von diesem Ersatzwert, also grafisch gesehen ausgehend von der Spitze des Ersatzvektors, wird die Berechnung für die zweite Windenergieanlage II durchgeführt. Das bedeutet, dass er als Nullpunkt für den phasenstarren Anteil fungiert, der zu einer horizontalen Verschiebung entlang der realen Achse führt. Dies ist dargestellt durch den gestrichelten Pfeil nähe der Ziffer II. Um die Spitze dieses Pfeils ist wiederum der Drehzeiger für den phasenvariablen Teil in einer durchgezogenen Linie dargestellt. Da die zweite Windenergieanlage II eine andere mittlere Phasenlage hat bezüglich ihrer phasenvariablen Oberschwingung ist der für sie auf die gleiche Weise wie für die Windenergieanlage I berechnete Ersatzvektor (strichpunktierter Pfeil nahe der Ziffer II) anders orientiert als der Ersatzvektor für die Windenergieanlage I. Es erfolgt also eine vektorielle Addition der beiden Ersatzvektoren. Mittels des Iterationsmodüls 62 und des Summiermoduls 63 wird dieser Vorgang für die dritte Windenergieanlage III wiederholt, woraus sich der dritte Ersatzvektor ergibt, welcher durch den strichpunktierten Pfeil nahe der Ziffer III in Figur 6 dargestellt ist. Das Summiermodul 63 bildet schließlich aus diesen drei Ersatzvektoren einen Gesamtvektor T, der durch eine dicke durchgezogene Linie dargestellt ist. Er repräsentiert den Mittelwert des von den Windenergieanlagen I - III unter Berücksichtigung der jeweiligen phasenstarren und phasenvariablen Anteile und deren relativer Phasenlage insgesamt erzeugten Oberschwingungsbeitrags.

Führt man dieses Verfahren für eine größere Anzahl von Windenergieanlagen durch, beispielsweise für etwa 100 Windenergieanlagen, so ergibt sich der in Figur 7 dargestellte Verlauf. Man erkennt aus dem Gesamtverlauf eine Kennlinie, wie sie qualitativ einer Quadratwurzeldarstellung entspricht. Das bedeutet, dass gemäß den erfindungsgemäßen Oberschwingungsprädiktor die gesamten Oberschwingungen eines Windparks einer entsprechend großen Anzahl N von Windenergieanlagen sich nicht entsprechend N-fach erhöhen, sondern etwa einer 1/√(N) folgt. Damit kann mit dem erfindungsgemäßen Prädiktor auch für Windenergieanlagen, deren Oberschwingung gemischt sind in dem Sinne, dass sie phasenstarre und phasenvariable Anteile aufweist, das Gesamtverhalten eines Windparks entsprechend abgeschätzt werden. Das Einhalten der Grenzwerte am Anschlusspunkt 3 an das öffentliche Netz 9 ist damit erleichtert.

Der erfindungsgemäße Oberschwingungsprädiktor kann dazu dienen, dass Umrichter 11 für Generatoren 10 der Windenergieanlagen 1 so angesteuert werden, dass deren Oberschwingung in Bezug auf den phasenstarren und phasenvariablen Teil so eingestellt sind, dass der von dem Oberschwingungsprädiktor 6 bestimmte Gesamtvektor T den Oberschwingungsgrenzwert LIMIT nicht überschreitet. Außer der Einstellung des Umrichters 11 kann auch vorgesehen sein, dass in kritischen Fällen die Anzahl N der Windenergieanlagen reduziert wird, um so eine Reduktion der Oberschwingung zu erreichen. Es sei angemerkt, dass das Prinzip des Oberschwingungsprädiktors an sich für jede Art von Windenergieanlagen 1 angewendet werden kann, es hat sich insbesondere bei Windenergieanlagen mit doppelt gespeisten Asynchrongenerator 10 bewährt. Gerade bei diesen tritt besonders das Problem des Mischfalls auf, also einer Oberschwingung mit phasenstarrem und phasenvariablem Teil.

Erfindungsgemäß ist es nicht zwingend erforderlich, dass der Oberschwingungsprädiktor 6 an einem echten Windpark implementiert ist. Es ist auch möglich, den Oberschwingungsprädiktor 6 an einem Simulationsinterface 7 (s. Fig. 2) anzuschließen, welches mit einem Simulationsrechner 70 zusammenwirkt. Das Simulationsinterface 7 zusammen mit dem Simulationsrechner 70 bilden das elektrische Verhalten des Windparks mit seinen Windenergieanlagen 1, dem internen Leitungsnetz 2 bis hin zum Anschlusspunkt 3 ab. Auf diese Weise kann mittels des Oberschwingungsprädiktors 6 das Verhalten des Windparks in Bezug auf seine Oberschwingung bereits ermittelt und bei der Auslegung des Windparks berücksichtigt werden, bevor er überhaupt tatsächlich gebaut wird. Dies ermöglicht eine wesentlich genauere Auslegung des Windparks. Das Simulationsinterface 7 weist dazu einen Anschluss 74 zur Simulation des Signalnetzes mit den daran angeschlossenen Einrichtungen und einen Anschluss 77 zum Anlegen eines Ausgangssignals 67' des Oberschwingungsprädiktors 6 ab.

Die mit dem erfindungsgemäßen Oberschwingungsprädiktor möglichen Verbesserungen sind in Figur 3 dargestellt. Der angestrebte Idealzustand ist eine Reduktion der Oberschwingung mit einem Reduktionsfaktor RF gemäß einer Beziehung 1/√(N), wie sie herkömmlicherweise lediglich bei Oberschwingungen höherer Ordnung erreicht werden kann; dieser ist in Figur 3 durch eine punktierte Linie dargestellt. Mit dem erfindungsgemäßen Oberschwingungsprädiktor kann eine Reduktion erreicht werden, wie sie durch die durchgezogene Linie dargestellt ist. Man erkennt, dass zwar keine ganz so starke Reduktion erreicht wird wie bei den Oberschwingungen höherer Ordnung, aber dennoch eine beträchtliche Verbesserung erreicht wird gegenüber dem bisherigen Fall, bei dem keine Reduktion, sondern ein Konstantwert von 1 gemäß der gestrichelten Linie anzunehmen war.

Damit kann mit dem erfindungsgemäßen Oberspannungsprädiktor die Oberschwingungsbelastung genauer eingeschätzt werden, was letztendlich den Anschluss von mehr Windenergieanlagen in einem Windpark bei einem gegebenen Anschluss mit vorgegebenen Oberschwingungsgrenzwert ermöglicht. Besonders erfreulich ist, dass mit dem Oberschwingungsprädiktor bereits bei verhältnismäßig kleinen Windparks mit zehn oder zwanzig Anlagen eine beträchtliche Reduktion der Oberschwingungsbelastung ermöglicht ist.

## Patentansprüche

1. Windpark mit mindestens zwei Windenergieanlagen (1), die jeweils einen Generator (10) mit einem Umrichter (11) zur Erzeugung elektrischer Energie aufweisen
**dadurch gekennzeichnet dass**,
ein Oberschwingungsprädiktor (6) vorgesehen ist, der die vom Windpark erwartete Oberschwingung bestimmt zur Begrenzung auf einen Oberschwingungsgrenzwert, wobei der Oberschwingungsprädiktor (6) umfasst
ein Berechnungsmodul (61), das einen komplexen Mittelwert über mindestens eine Periode der Oberschwingung einer der Windenergieanlagen I berechnet und daraus einen ersten Ersatzvektor bestimmt, dessen Betrag der mittleren Amplitude der Oberschwingung entspricht,
ein Iterationsmodul (62), welches das Berechnungsmodul (61) sukzessive auf mindestens eine andere der Windenergieanlagen II aufschaltet zur Bildung mindestens eines zweiten Ersatzvektors, und ein Summiermodul (63), welches die Ersatzvektoren aufaddiert zu einem Gesamtvektor T und mit dem Oberschwingungsgrenzwert vergleicht.

2. Windpark nach Anspruch 1, **dadurch gekennzeichnet dass**, das Iterationsmodul (62) und das Summiermodul (63) zu einem Rekursionsmodul (64) kombiniert sind.

3. Windpark nach Anspruch 1 oder 2, **dadurch gekennzeichnet, dass** der Umrichter (11) bezüglich seines phasenstarren und phasenvariablen Teils der Oberschwingung einstellbar ist.

4. Windpark nach Anspruch 3, **dadurch gekennzeichnet, dass** der Oberschwingungsprädiktor (6) mit einem Limiter (68) zusammenwirkt, der durch Verstellen des Verhältnis zwischen phasenstarrer und phasenvariabler Teile die Oberschwingung auf den Grenzwert einstellt.

5. Windpark nach Anspruch 3 oder 4, **dadurch gekennzeichnet, dass** der Oberschwingungsprädiktor (6) mit dem Limiter (68) derart zusammenwirkt, dass durch Beschränken der Anzahl der elektrische Energie abgebenden Windenergieanlagen (1) die Oberschwingung auf den Grenzwert einstellt.

6. Windpark nach einem der vorangehenden Ansprüche, **dadurch gekennzeichnet, dass** die Oberschwingung eine gerade Ordnung aufweist, vorzugsweise höchstens bis zur 50. Ordnung, weiter vorzugsweise 20. Ordnung, und/oder im Bereich der Schaltfrequenz des Umrichters (11) liegt.

7. Oberschwingungsprädiktor für einen Windpark umfassend mindestens zwei Windenergieanlagen (1), die jeweils einen Generator (10) mit einem Umrichter (11) zur Erzeugung elektrischer Energie aufweisen, wobei ein Grenzwert für die vom Windpark generierte Oberschwingung bestimmt ist, **dadurch gekennzeichnet, dass** der Oberschwingungsprädiktor (6) umfasst:
ein Berechnungsmodul (61), das einen komplexen Mittelwert über mindestens eine Periode der Oberschwingung einer der Windenergieanlagen I berechnet und daraus einen ersten Ersatzvektor bestimmt, dessen Betrag der mittleren Amplitude der Oberschwingung entspricht,
ein Iterationsmodul (62), welches das Berechnungsmodul (61) sukzessive auf mindestens eine andere der Windenergieanlagen II aufschaltet zur Bildung mindestens eines zweiten Ersatzvektors, und ein Summiermodul (63), welches die Ersatzvektoren aufaddiert zu einem Gesamtvektor T und mit dem Oberschwingungsgrenzwert vergleicht.

8. Oberschwingungsprädiktor nach Anspruch 7, **dadurch gekennzeichnet, dass** er nach einem der Ansprüche 1 bis 6 weitergebildet ist.

9. Verfahren zum Begrenzen der von einem Windpark generierten Oberschwingung, wobei der Windpark mindestens zwei Windenergieanlagen (1) umfasst, die jeweils einen Generator (10) mit einem Umrichter (11) zur Erzeugung elektrischer Energie aufweisen
**gekennzeichnet durch**
für eine erste der Windenergieanlagen (I)
Berechnung eines komplexen Mittelwerts über mindestens eine Periode der Oberschwingung und daraus Bestimmen eines ersten Ersatzvektors mit Betrag und Winkel, wobei der Betrag der mittleren Amplitude der Oberschwingung entspricht,
für mindestens eine zweite der Windenergieanlagen (II)
iteratives Bestimmen eines zweiten Ersatzvektors auf die selbe Weise,
Verwenden des ersten Ersatzvektors als Fußpunkt für den zweiten Ersatzvektor zur Aufsummation, und
Bilden eines Gesamtvektors T und Vergleichen von diesem mit dem Oberschwingungsgrenzwert.

10. Verfahren nach Anspruch 9, **gekennzeichnet durch** rekursives Bestimmen und Aufaddieren von den Ersatzvektoren für weitere Windenergieanlagen (III).

11. Verfahren nach Anspruch 9 oder 10, durch gekennzeichnet, dass das Bestimmen eines Ersatzvektors umfasst ein Berechnen eines Mittelwerts eines Realteils der Oberschwingung der jeweiligen Windenergieanlagen.

12. Verfahren nach Anspruch 11, **dadurch gekennzeichnet, dass** das Bestimmen eines Ersatzvektors umfasst ein Berechnen eines Mittelwerts eines Imaginärteils der Oberschwingung.

13. Verfahren nach einem der Ansprüche 9 bis 12, **gekennzeichnet durch** Aufspalten der Oberschwingung in einen phasenstarren Teil und in einen phasenvariablen Teil.

14. Verfahren nach einem der Ansprüche 9 bis 13, **dadurch gekennzeichnet, dass** der Betrag des Ersatzvektors bestimmt ist durch einen Mittelwert des Betrags der Oberschwingung über mindestens eine Periode.

15. Verfahren nach einem der Ansprüche 12 bis 14, **dadurch gekennzeichnet, dass** der Winkel des Ersatzvektors bestimmt ist durch das Verhältnis der Mittelwerte von Imaginärteil zu Realteil.

16. Verfahren nach einem der Ansprüche 9 bis 15, **gekennzeichnet durch** Verstellen des Verhältnisses zwischen phasenstarrer und phasenvariabler Teile der Oberschwingung, um sie auf einen Grenzwert zu beschränken.

17. Verfahren nach einem der Ansprüche 9 bis 16, **gekennzeichnet durch** Begrenzen der Anzahl der Windenergieanlagen, um die Oberschwingung auf den Grenzwert zu beschränken.

## Claims

1. Wind farm with at least two wind turbines (1), each having a generator (10) with a converter (11) for generating electrical energy,
**characterized in that**
a harmonic predictor (6) which determines the harmonic component expected from the wind farm in order to limit it to a harmonic limit is provided, wherein the harmonic predictor (6) comprises
a calculation module (61) which calculates a complex mean value over at least one period of the harmonic component of one of the wind turbines I and determines a first equivalent vector therefrom, the magnitude of which corresponds to the mean amplitude of the harmonic component,
an iteration module (62) which successively connects the calculation module (61) to at least one other of the wind turbines II to form at least one second equivalent vector, and a summing module (63) which sums the equivalent vectors to form a total vector T and compares it with the harmonic limit.

2. Wind farm according to Claim 1, **characterized in that** the iteration module (62) and the summing module (63) are combined to form a recursion module (64).

3. Wind farm according to Claim 1 or 2, **characterized in that** the converter (11) is adjustable with regard to its fixed-phase and variable-phase part of the harmonic component.

4. Wind farm according to Claim 3, **characterized in that** the harmonic predictor (6) works together with a limiter (68) which sets the harmonic component to the limit by adjusting the ratio between fixed-phase and variable-phase parts.

5. Wind farm according to Claim 3 or 4, **characterized in that** the harmonic predictor (6) works together with the limiter (68) in such a way that the harmonic component is set to the limit by restricting the number of wind turbines (1) which emit electrical energy.

6. Wind farm according to one of the preceding claims, **characterized in that** the harmonic component is of an even order, preferably no greater than the 50th order, furthermore preferably 20th order, and/or lies in the region of the switching frequency of the converter (11).

7. Harmonic predictor for a wind farm comprising at least two wind turbines (1), each having a generator (10) with a converter (11) for generating electrical energy, wherein a limit for the harmonic component generated by the wind farm is determined, **characterized in that** the harmonic predictor (6) comprises:
a calculation module (61) which calculates a complex mean value over at least one period of the harmonic component of one of the wind turbines I and determines a first equivalent vector therefrom, the magnitude of which corresponds to the mean amplitude of the harmonic component,
an iteration module (62) which successively connects the calculation module (61) to at least one other of the wind turbines II to form at least one second equivalent vector, and a summing module (63) which sums the equivalent vectors to form a total vector T and compares it with the harmonic limit.

8. Harmonic predictor according to Claim 7, **characterized in that** it is improved in accordance with one of Claims 1 to 6.

9. Method for limiting the harmonic component generated by a wind farm, wherein the wind farm comprises at least two wind turbines (1), each having a generator (10) with a converter (11) for generating electrical energy,
**characterized by**
for a first of the wind turbines (I)
calculation of a complex mean value over at least one period of the harmonic component and determination therefrom of a first equivalent vector with magnitude and angle, wherein the magnitude corresponds to the mean amplitude of the harmonic component,
for at least one second of the wind turbines (II)
iterative determination of a second equivalent vector in the same manner,
use of the first equivalent vector as the foot of the second equivalent vector for summation, and
formation of a total vector T and its comparison with the harmonic limit.

10. Method according to Claim 9, **characterized by** recursive determination and summation of the equivalent vectors for further wind turbines (III).

11. Method according to Claim 9 or 10, **characterized in that** the determination of an equivalent vector comprises a calculation of a mean value of a real part of the harmonic component of the respective wind turbines.

12. Method according to Claim 11, **characterized in that** the determination of an equivalent vector comprises a calculation of a mean value of an imaginary part of the harmonic component.

13. Method according to one of Claims 9 to 12, **characterized by** splitting the harmonic component into a fixed-phase part and into a variable-phase part.

14. Method according to one of Claims 9 to 13, **characterized in that** the magnitude of the equivalent vector is determined by a mean value of the magnitude of the harmonic component over at least one period.

15. Method according to one of Claims 12 to 14, **characterized in that** the angle of the equivalent vector is determined by the ratio of the mean values of imaginary part to real part.

16. Method according to one of Claims 9 to 15, **characterized by** adjusting the ratio between fixed-phase and variable-phase parts of the harmonic component in order to restrict it to a limit.

17. Method according to one of Claims 9 to 16, **characterized by** limiting the number of wind turbines in order to restrict the harmonic component to the limit.

## Revendications

1. Parc éolien comprenant au moins deux éoliennes (1) qui présentent chacune un générateur (10) avec un convertisseur (11) pour la production d'énergie électrique,
**caractérisé**
**en ce qu'**il est prévu un prédicteur d'harmonique (6) qui détermine l'harmonique prévu par le parc éolien en vue de la limitation à une valeur limite d'harmonique, le prédicteur d'harmonique (6) comprenant:
un module de calcul (61) qui calcule une valeur moyenne complexe au cours d'au moins une période de l'harmonique d'une des éoliennes I et détermine à partir de celle-ci un premier vecteur de remplacement dont la hauteur correspond à l'amplitude moyenne de l'harmonique,
un module d'itération (62) qui commute successivement le module de calcul (61) sur au moins une autre des éoliennes II en vue de la formation d'au moins un deuxième vecteur de remplacement, et un module totalisateur (63) qui additionne les vecteurs de remplacement pour obtenir un vecteur total T et compare celui-ci avec la valeur limite d'harmonique.

2. Parc éolien selon la revendication 1, **caractérisé en ce que** le module d'itération (62) et le module totalisateur (63) sont combinés de façon à former un module de récursion (64).

3. Parc éolien selon la revendication 1 ou 2, **caractérisé en ce que** le convertisseur (11) peut être réglé par rapport à la partie de l'harmonique à phase fixe et à phase variable.

4. Parc éolien selon la revendication 3, **caractérisé en ce que** le prédicteur d'harmonique (6) coopère avec un limiteur (68) qui règle l'harmonique à la valeur limite en adaptant le rapport entre les parties à phase fixe et à phase variable.

5. Parc éolien selon la revendication 3 ou 4, **caractérisé en ce que** le prédicteur d'harmonique (6) coopère avec un limiteur (68) de telle sorte que l'harmonique est réglé à la valeur limite par une limitation du nombre d'éoliennes (1) qui fournissent de l'énergie électrique.

6. Parc éolien selon l'une des revendications précédentes, **caractérisé en ce que** l'harmonique présente un ordre pair, de préférence au maximum jusqu'au 50^{e} ordre, et plus de préférence jusqu'au 20^{e} ordre, et/ou se situe dans la zone de la fréquence de commutation du convertisseur (11).

7. Prédicteur d'harmonique pour un parc éolien comprenant au moins deux éoliennes (1) qui présentent chacune un générateur (10) avec un convertisseur (11) pour la production d'énergie électrique, une valeur limite étant déterminée pour l'harmonique engendré par le parc éolien, **caractérisé en ce que** le prédicteur d'harmonique (6) comprend:
un module de calcul (61) qui calcule une valeur moyenne complexe au cours d'au moins une période de l'harmonique d'une des éoliennes I et détermine à partir de celle-ci un premier vecteur de remplacement dont la hauteur correspond à l'amplitude moyenne de l'harmonique,
un module d'itération (62) qui commute successivement le module de calcul (61) sur au moins une autre des éoliennes II en vue de la formation d'au moins un deuxième vecteur de remplacement, et un module totalisateur (63) qui additionne les vecteurs de remplacement pour obtenir un vecteur total T et compare celui-ci avec la valeur limite d'harmonique.

8. Prédicteur d'harmonique selon la revendication 7, **caractérisé en ce qu'**il est également réalisé selon l'une des revendications 1 à 6.

9. Procédé destiné à limiter l'harmonique engendré par un parc éolien, le parc éolien comprenant au moins deux éoliennes (1) qui présentent chacune un générateur (10) avec un convertisseur (11) pour la production d'énergie électrique,
**caractérisé par**
pour une première des éoliennes (I) le calcul d'une valeur moyenne complexe au cours d'au moins une période de l'harmonique et la détermination à partir de celle-ci un premier vecteur de remplacement, avec une hauteur et un angle, la hauteur correspondant à l'amplitude moyenne de l'harmonique,
pour au moins une deuxième des éoliennes (II)
la détermination par itération d'un deuxième vecteur de remplacement de la même manière,
l'utilisation du premier vecteur de remplacement en tant que pied pour le deuxième vecteur de remplacement en vue de la totalisation, et
la formation d'un vecteur global T et la comparaison de celui-ci avec la valeur limite d'harmonique.

10. Procédé selon la revendication 9, **caractérisé par** la détermination par récursion et l'addition des vecteurs de remplacement pour des éoliennes (III) supplémentaires.

11. Procédé selon la revendication 9 ou 10, **caractérisé en ce que** la détermination d'un vecteur de remplacement comprend un calcul d'une valeur moyenne d'une partie réelle de l'harmonique des éoliennes respectives.

12. Procédé selon la revendication 11, **caractérisé en ce que** la détermination d'un vecteur de remplacement comprend un calcul d'une valeur moyenne d'une partie imaginaire de l'harmonique.

13. Procédé selon l'une des revendications 9 à 12, **caractérisé par** la division de l'harmonique dans une partie à phase fixe et une partie à phase variable.

14. Procédé selon l'une des revendications 9 à 13, **caractérisé en ce que** la hauteur du vecteur de remplacement est déterminé par une valeur moyenne de la hauteur de l'harmonique au cours d'au moins une période.

15. Procédé selon l'une des revendications 12 à 14, **caractérisé en ce que** l'angle du vecteur de remplacement est déterminé par le rapport entre les valeurs moyennes de la partie imaginaire et la partie réelle.

16. Procédé selon l'une des revendications 9 à 15, **caractérisé par** une adaptation du rapport entre les parties de l'harmonique à phase fixe et à phase variable afin de limiter celle-ci à une valeur limite.

17. Procédé selon l'une des revendications 9 à 16, **caractérisé par** une limitation du nombre d'éoliennes afin de limiter l'harmonique à la valeur limite.
